(19) Europäisches Patentamt
European Patent Office
Office européen des brevets

(11) **EP 3 568 380 B1**

(12) **EUROPÄISCHE PATENTSCHRIFT**

(45) Veröffentlichungstag und Bekanntmachung des Hinweises auf die Patenterteilung:
**09.06.2021 Patentblatt 2021/23**

(21) Anmeldenummer: **18700667.1**

(22) Anmeldetag: **15.01.2018**

(51) Int Cl.:
*C04B 26/06* (2006.01)   *C04B 26/12* (2006.01)
*C04B 28/02* (2006.01)   *C04B 28/14* (2006.01)
*C04B 28/26* (2006.01)   *H01B 1/04* (2006.01)
*C04B 20/10* (2006.01)   *C04B 111/94* (2006.01)

(86) Internationale Anmeldenummer:
**PCT/EP2018/050910**

(87) Internationale Veröffentlichungsnummer:
**WO 2018/130699 (19.07.2018 Gazette 2018/29)**

(54) **BAUSTOFFMISCHUNG ZUR ABSCHIRMUNG ELEKTROMAGNETISCHER STRAHLUNG**

BUILDING MATERIAL MIXTURE FOR SHIELDING AGAINST ELECTROMAGNETIC RADIATION

MÉLANGE DE MATÉRIAUX DE CONSTRUCTION POUR PROTÉGER DU RAYONNEMENT ÉLECTROMAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.01.2017   DE 102017000236**

(43) Veröffentlichungstag der Anmeldung:
**20.11.2019   Patentblatt 2019/47**

(73) Patentinhaber: HEKA graphit.technology GmbH
19288 Ludwigslust (DE)

(72) Erfinder: **DÜWEL, Jens**
**19288 Ludwigslust (DE)**

(74) Vertreter: **Reitstötter Kinzebach**
**Patentanwälte**
**Sternwartstrasse 4**
**81679 München (DE)**

(56) Entgegenhaltungen:
WO-A1-01/38084        WO-A1-02/13311
WO-A1-2016/087673     DE-A1-102011 007 834

**Beschreibung**

Die vorliegende Erfindung betrifft eine Baustoffmischung zur Abschirmung elektromagnetischer Strahlung, beispielsweise eine Baustoffmischung, die als Putzmasse oder als Grundmaterial zur Herstellung von Bauelementen, insbesondere Trockenbauelementen, eingesetzt werden kann.

Die wachsende digitale Vernetzung aller Arbeits- und Lebensbereiche, sowie der Ausbau kabelloser Kommunikation und Datenübertragung führt zu einer immer stärkeren Zunahme elektromagnetischer Strahlung, insbesondere in hochfrequenteren Bereichen, was als so genannter "Elektrosmog" bezeichnet wird. Dieser Elektrosmog ist nicht nur ein arbeitsschutztechnisches und gesundheitliches Problem, sondern sich überlagernde elektromagnetische Felder stellen in vielen Bereichen auch technische, insbesondere sicherheitstechnische Probleme für Industrie, Verwaltung und sicherheitsrelevante Einrichtungen dar. Bekannte Abschirmlösungen gegen elektromagnetische Strahlung basieren auf der Reflexion elektromagnetischer Strahlung, was zwar die in einen entsprechend abgeschirmten Raum eindringende elektromagnetische Strahlung minimiert, aber insgesamt nicht wesentlich verringert, da die Strahlung letztlich nur in andere Bereiche reflektiert wird.

In der internationalen Patentanmeldung WO 2016/087673 A1 der Anmelderin wird eine graphithaltige Baustoffmischung beschrieben, welche aufgrund ihrer hohen Wärmeleitfähigkeit in Form einer Spachtel- oder Putzmasse für Flächenheizungen und Ähnliches verwendet werden kann. Die aus der bekannten Baustoffmischung hergestellten Spachtelmassen zeichnen sich aufgrund ihrer hohen elektrischen Leitfähigkeit auch durch ein hohes Reflexionsvermögen für elektromagnetische Wellen, insbesondere für hochfrequente elektromagnetische Wellen, wie beispielsweise Mobilfunkstrahlung oder Radarstrahlung, aus. Auch diese Spachtelmasse kann auftreffende elektromagnetische Strahlung nicht wirksam minimieren.

Der vorliegenden Erfindung liegt daher das technische Problem zugrunde, eine Baustoffmischung der oben beschriebenen Art anzugeben, welche elektromagnetische Strahlung, insbesondere hochfrequente elektromagnetische Strahlung, nicht nur reflektiert, sondern zum größten Teil absorbiert, so dass die elektromagnetische Strahlung nicht nur am Durchdringen von Barrieren gehindert, sondern insgesamt deutlich reduziert wird.

Die Baustoffmischung soll als Putzmasse verwendet werden können. Insbesondere soll die Putzmasse im abgebundenen Zustand eine extrem hohe elektromagnetische Abschirmung vorrangig durch Absorption aufweisen. Ziel ist es, dass die Strahlung innerhalb der Materialstärke im Schirm in Wärme umgewandelt und damit vernichtet wird. Die Strahlenschirmung durch Reflexion soll weitestgehend verringert und gar ganz vermieden werden. Weiterhin soll die Putzmasse eine sehr hohe Wärmeleitfähigkeit besitzen, um Flächenheizsysteme zu unterstützen. Die ausgehärtete Baustoffmischung soll in der weiteren Verarbeitung überstreichbar, tapezierbar, mit Fliesen und anderen Baustoffen beschichtbar sein. Die Baustoffmischung soll per Hand oder maschinell auf die zu beschichtenden Oberflächen aufgetragen werden können. Ebenso soll die Baustoffmischung in Formen verpressbar/vergießbar sein und über einen 3D-Drucker verarbeitbar sein.

Gelöst wird dieses technische Problem durch eine Baustoffmischung mit den Merkmalen des vorliegenden Anspruchs 1. Vorteilhafte Weiterbildungen der erfindungsgemäßen Baustoffmischung sind Gegenstand der abhängigen Patentansprüche.

Die Erfindung betrifft demnach eine Baustoffmischung, deren Trockenmasse 10 bis 95 Gew.% Kohlenstoff und 2 bis 70 Gew.% Bindemittel umfasst, wobei die erfindungsgemäße Baustoffmischung dadurch gekennzeichnet ist, dass die Baustoffmischung außerdem 1 bis 80 Gew.% lose Partikel umfasst, wobei die Oberfläche der losen Partikel zumindest teilweise mit einem elektrisch leitfähigen Material vorbeschichtet sind, wobei der beschichtete Anteil der Oberfläche der losen Partikel im Mittel zwischen 50 und 90% beträgt.

Wenn in der vorliegenden Beschreibung Komponenten der Baustoffmischung in Gewichtsprozent angegeben werden, versteht sich, dass lediglich solche Kombinationen von Komponenten umfasst sind, deren Summe der Bestandteile, abgesehen von herstellungsbedingten Verunreinigungen, 100 Gew.% ergeben. Die Anteile der Komponenten verstehen sich stets bezogen auf die Trockenmasse, d. h. ohne Anmachflüssigkeiten, wie beispielsweise Wasser.

Die Konzentrationen der Komponenten der erfindungsgemäßen Baustoffmischung umfassen alle explizit genannten, aber auch alle nicht explizit genannten Werte, die in die beanspruchten Bereiche fallen.

Exemplarisch beträgt die Obergrenze des Anteilintervalls an Kohlenstoff 95, 90, 85 oder 80 Gew.(%). Als Untergrenze gelten zum Beispiel folgende Werte: 20, 25, 30, 35, 40, 45, 50 Gew.(%). Die Offenbarung dieser Anmeldung umfasst auch die Menge von allen Intervallen, die durch alle möglichen Kombinationen vorgenannten ober und Untergrenzen definiert werden.

Des Weiteren beträgt die Obergrenze des Anteilintervalls an Bindemittel beispielsweise 70, 65, 60, 55, 50 oder 45 Gew(%). Als Untergrenze kommen zum Beispiel folgende Werte in Frage: 2, 4, 7, 10, 15, 20, 25, 30, 35 oder 40 Gew(%). Die Offenbarung dieser Anmeldung umfasst wiederum die Menge von allen Intervallen, die durch alle möglichen widerspruchsfreien Kombinationen der vorgenannten Ober - und Untergrenzen definiert werden.

Die mit einem elektrisch leitfähigen Material beschichteten losen Partikel erzeugen vielfach Reflexionen der in die Baustoffmischung eindringenden elektromagnetischen Strahlung, so dass ein Großteil der elektromagnetischen Strahlung in der Baustoffmischung absorbiert werden kann, was den reflektierten oder transmittierten Anteil der elektromagnetischen Strahlung verringert.

Durch Anpassung/Änderung der Konzentrationen der einzelner Bestandteile, insbesondere des Bulk-Anteils an Kohlenstoff und des Anteil der elektrisch leitfähigen Beschichtung können die Absorptions- und Reflexionseigenschaften in weiten Bereichen verändert und an die jeweils gewünschten Eigenschaften der Endprodukte angepasst werden.

Die Beschichtung der losen Partikel kann bei der Herstellung der Baustoffmischung erfolgen, beispielsweise können unbeschichtete lose Partikel der Baustoffmischung einen Teil des in der Baustoffmischung enthaltenen Kohlenstoffs in Form einer Oberflächenbeschichtung anlagern.

Gemäß der Erfindung enthält die Baustoffmischung lose Partikel, die mit dem elektrisch leitfähigen Material vorbeschichtet sind. Unter "vorbeschichteten losen Partikeln" versteht man im vorliegenden Zusammenhang Partikel, bei denen vor Zugabe zur Baustoffmischung ein elektrisch leitfähiges Material auf die Partikeloberfläche aufgebracht wurde. Vorzugsweise wird dabei ein Haftvermittler, beispielsweise ein Klebstoff verwendet, um das Anhaften des elektrisch leitfähigen Materials auf der Partikeloberfläche zu verbessern.

Es werden lose Partikel verwendet, deren Oberfläche nicht vollständig mit elektrisch leitfähigem Material beschichtet ist. Der beschichtete Anteil der Oberfläche der losen Partikel im Mittel beträgt zwischen 50 und 90%. Somit wird der Absorptionsgrad für elektromagnetische Strahlung weiter verbessert, denn elektromagnetische Strahlung kann in den unbeschichteten Bereichen in die Partikel eintreten und wird an den beschichteten Grenzflächen mehrfach reflektiert, was die Absorption der Strahlung innerhalb der Partikel erhöht.

Die losen Partikel können aus unterschiedlichsten Materialien bestehen, vorzugsweise bestehen die Partikel jedoch aus Glas- oder Keramikmaterialien.

Auch die Geometrie der losen Partikel unterliegt keinerlei Einschränkung. Im Hinblick auf eine besonders effektive Absorption handelt es sich bei den losen Partikeln jedoch vorzugsweise um Kugeln, insbesondere um Hohlkugeln, beispielsweise Hohlkugeln aus Glas, wie beispielsweise Mikroglaskügelchen (Glas-Microbubbles). Als geeignete lose Partikel kommt beispielsweise das in unterschiedlichsten Größen und Größenverteilungen von der Fa. Dennert Poraver GmbH, Postbauer-Heng, Deutschland unter der Produktbezeichnung "Poraver" vertriebene Blähglasgranulat in Frage.

Die Größe der losen Partikel, also beispielsweise im Fall von Kugeln der Kugeldurchmesser, liegt vorzugsweise im Bereich von 0,01 mm bis 10 mm.

Der Volumenanteil der beschichteten losen Partikel, beispielsweise der beschichteten Kugeln in der Baustoffmischung kann hoch sein und beispielsweise mehr als 50 Vol.%, oder sogar mehr als 75 Vol.%, betragen.

Gemäß einer Ausführungsform umfasst der Kohlenstoff der Trockenmasse Graphit bzw. besteht der Kohlenstoff der Trockenmasse aus Graphit.

Gemäß einer weiteren Ausführungsform der erfindungsgemäßen Baustoffmischung ist das elektrisch leitfähige Material ausgewählt aus der Gruppe bestehend aus Magnetit ($Fe_3O_4$), Graphit und Graphen oder Kombinationen dieser Materialien.

Magnetit wird in der Bauindustrie bereits als natürlich gekörnter Zuschlag mit hoher Rohdichte (4,65 bis 4,80 kg/dm$^3$) für Kalksandsteine und Schwerbeton und für bautechnischen Strahlenschutz verwendet. Daher kann Magnetit im vorliegenden Zusammenhang nicht nur als Beschichtung für die losen Partikel, sondern auch als Zuschlagsstoff für die Baustoffmischung verwendet werden.

Bevorzug wird für die losen Partikel jedoch eine Beschichtung auf Kohlenstoffbasis wie Graphit oder Graphen verwendet, d.h. bei der erfindungsgemäßen Baustoffmischung kommt bei bevorzugten Ausführungsformen Kohlenstoff sowohl im Bulkmaterial als auch als Beschichtung vor.

Der Graphit als Bestandteil der Trockenmasse oder der Graphit als Beschichtung der losen Partikel kann als Graphitpulver, als expandierte Graphitflocken, als Foliengraphit, Naturgraphit oder synthetischer Graphit vorliegen. Die Erfindung lässt sich mit einen Vielzahl verschiedener Varianten von Graphit realisieren, was für die Vielfältigkeit der Erfindung spricht. Die hier beschriebene Liste ist nicht abschließend sondern nur beispielhaft.

Besonders bevorzugt sind die losen Partikel mit Graphen beschichtet. Graphen ist eine Modifikation des Kohlenstoffs mit zweidimensionaler Struktur, wobei jedes Kohlenstoffatom im Winkel von 120° von drei weiteren Kohlenstoffatomen umgeben ist, so dass sich, ähnlich wie bei den Schichten des Graphit, eine wabenförmige Kohlenstoffstruktur ausbildet. Im Gegensatz zum Graphit besteht Graphen allerdings aus einer einzigen Lage Kohlenstoff und zeichnet sich durch besonders hohe mechanische Stabilität in der Ebene, sowie hohe elektrische Leitfähigkeit in dieser Ebene aus.

Bei der erfindungsgemäßen Baustoffmischung können unterschiedlichste Bindemittel eingesetzt werden, wie beispielsweise Kalk, Zement, Gips, Kunststoffe, wie insbesondere Acrylate oder Polyurea-Silikate, organische Bindemittel, Wasserglas, wasserlösliche Kleber oder Klebstoffe.

Als Wasserglas werden aus einer Schmelze erstarrte, glasartige, also amorphe, wasserlösliche Natrium-, Kalium- und Lithiumsilicate bezeichnet.

Polyurea-Silikate wurden als Zweikomponenten-Injektionsharze für die Bergbauindustrie entwickelt. Diese organo-mineralischen Systeme basieren auf der Reaktion von modifizierten Polyisocyanaten mit speziell formulierten Wasserglaskomponenten und Beschleunigern. Die Polyurea-Silikatharze zeichnen sich durch bessere technische Eigenschaften gegenüber den herkömmlichen Polyurethanen, Aminoplasten und bekannten Silikatharzen auf Polyurethanbasis aus.

Die erfindungsgemäße Baustoffmischung kann außerdem bis zu 50 Gew.% Funktionsadditive umfassen.

Die erfindungsgemäße Baustoffmischung zeichnet sich durch eine Zusammensetzung von mindestens drei, bevorzugt vier Bestandteilen aus. Die Anteile der Bestandteile sind durch Intervalle definiert, die durch eine obere und untere Grenze beschrieben sind.

Beispielhaft beträgt die Obergrenze des Anteilintervalls an Funktionsadditiven 50, 45, 40, 35, 30 oder 25 Gew.(%). Als Untergrenze kommen zum Beispiel folgende Werte in Frage: 0, 3, 6, 10, 13, 16 oder 20 Gew.(%). Die Offenbarung dieser Anmeldung umfasst wieder die Menge von allen Intervallen, die durch alle möglichen widerspruchsfreien Kombinationen der vorgenannten Ober- und Untergrenzen definiert werden.

Als Funktionsadditive kommen beispielsweise Trasspulver, Mikroglashohlkugeln (Glass-Bubbles), Aluminiumoxid, Entschäumer, Magnetit, Schwerspat, Verdickungsmittel, Zellulose, Kunststoffadditive, metallische Nanopartikel, insbesondere Silber-Nanopartikel, Fasern oder Kombinationen davon in Frage.

Bei der Verwendung von Mikroglashohlkugeln als Funktionsadditive kann die erfindungsgemäße Baustoffmischung also sowohl aus unbeschichteten als auch aus mit einem elektrisch leitfähigen Material beschichteten Glaskugeln bestehen.

Metallische Nanopartikel, wie Silber-Nanopartikel, können eingesetzt werden, um dem Material desinfizierende bzw. keimtötende Eigenschaften zu verleihen.

Fasern können beispielsweise zur mechanischen Stabilisierung eingesetzt werden, beispielsweise kommen als Glasfasern, Basaltfasern und Kohlefasern oder Kunststofffasern als funktionelle Additive in Frage. Es können auch metallische Fasern zur Modifikation der elektrischen, magnetischen und thermischen Eigenschaften der Baustoffmischung eingesetzt werden.

Als Funktionsadditiv kommt auch Baryt (Schwerspat) in Frage, der insbesondere zur Versbesserung der Abschirmeigenschaften der Baustoffmischung gegen Röntgenstrahlung eingesetzt werden kann.

Als Funktionsadditiv können außerdem verwendet werden: Sand, Kies, Borsilikate, quellfähige Verdicker, assoziativ wirkende Verdicker, Antiabsetzmittel, Bentone, Eisenoxyd und weitere für den Fachmann übliche Hilfsstoffe.

Es kann auch Aluminiumpulver als Funktionsadditiv beigefügt werden, beispielsweise das von der Fa. GRIMM Metallpulver GmbH, Roth, Deutschland unter dem Markennamen "EXPANDIT" vertriebene Aluminiumpulver. Das Aluminium dient als Expansionsmittel. Die erfindungsgemäße Baustoffmischung kann dann gleichmäßig verteilte, winzige Aluminiumpartikel enthalten. Diese Aluminiumteilchen bewirken bei Kontakt mit Wasser die Bildung von Wasserstoffgas in Form von zahllosen kleinen Bläschen in der Mischung. Es entsteht so ein hochporöser Schaum, der sich je nach Bindemittel schnell verfestigen kann.

Zum Beispiel wird durch Zugabe von quellfähigen Verdickern und schnellabbindendem Zement wie Aluminium-Schmelzzement eine standfeste schnellabbinde Masse hergestellt, welche beim 3D-Drucken stabil stehen bleibt und nicht zerläuft. Der Einsatz von Trasspulver bewirkt, dass die Oberflächen Festigkeit der sich ausbildenden Schicht beeinflusst bzw. verbessert werden kann.

Der Einsatz von Glas-Bubbles, die als Mikroperlen eingesetzt werden, sorgen für eine Art Hohlraum in der Mischung, welche von den abschirmenden Materialien wie zum Beispiel Graphit, Graphen, Nano-Metallpartikeln und weiteren nicht genannten Additiven umgeben ist. Diese "Hohlräume" sorgen für die Absorption, da sich die Strahlungen in der Schicht reflektieren und somit wird die Strahlung weitestgehend im Schirm (Baustoffmischung) eliminiert. Es können auch andere nicht leitende Zuschlagsstoffe für die Bildung der "Hohlräume" genommen werden. Ebenso können durch Schäumende Zuschläge auch Hohlräume geschaffen werden, die auch diese Aufgabe übernehmen. Kunststoffadditive bewirken, dass dadurch die Haftung auf dem Untergrund eingestellt werden kann. Des Weiteren kann dadurch auch der Verlauf reguliert werden.

Die faserhaltigen Baustoffmischungen können beispielsweise zu Strängen extrudiert werden, welche den Fasern eine gewisse Vorzugsrichtung aufprägen. Wenn die Stränge dann überkreuz angeordnet und zu Platten verpresst werden, entsteht ein hochstabiles Netzwerk aus der erfindungsgemäßen Baustoffmischung, welches den so hergestellten Platten überragende mechanische Festigkeitswerte vermittelt.

Die Erfindung betrifft auch eine Putzmasse umfassend eine Baustoffmischung der oben beschriebenen Art.

Hier unterscheidet sich die Erfindung gegenüber Standard-Putzsystemen vor allem durch die Absorption von elektromagnetischen Strahlungen im HF-Bereich. Der Anteil der Absorption ist Höher als 50% gegenüber der Reflexion.

In einer vorteilhaften Ausgestaltung ist vorgesehen, dass die verarbeitete Baustoffmischung als Schicht in einer Schichtdicke von ca. 1,0 cm aufgetragen, eine Absorption von 40 % erreicht. Bei einer Schichtstärke von 2 cm konnte eine Absorption von 72% ermittelt werden. Dieses hervorragende Absorptionsverhalten unterscheidet sich von allen auf dem Markt befindlichen Putzsystemen.

Die Baustoffmischung, beziehungsweise der hieraus hergestellten Baustoff wird als Abschirmmaterial vorwiegend mit einer Absorption von über 50 % verwendet.

Die (trockene) Baustoffmischung ist eine im Handel verfügbare und genutzte Ausgestaltung der Erfindung, wenngleich sich die beschriebenen physikalischen Eigenschaften erst bei einer Schicht, die aus der beschriebenen Baustoffmischung gebildet ist, nachweisbar sind.

Daher umfasst die Erfindung auch allgemein einen Baustoff, welcher zumindest teilweise aus einer Baustoffmischung, wie vorbeschrieben, gebildet ist.

Bei einer bevorzugten Ausgestaltung ist vorgesehen, dass der Baustoff zwischen 5 und 70 Gew.(%) einer Anmachflüssigkeit, wie beispielsweise Wasser, enthält. Für den Wasseranteil an dem Baustoff wird ein Intervall angegeben, das durch eine obere und untere Grenze beschrieben ist. Als Obergrenze sind zum Beispiel dabei folgende Werte denkbar: 70 %, 65 %, 60%, 55%, 50%. Als Untergrenze kommen beispielsweise folgende Werte in Frage: 5%, 10%, 15%, 20 % Die Offenbarung dieser Anmeldung umfasst die Menge von allen Intervallen, die durch alle möglichen, widerspruchsfreien Kombinationen der vorgenannten Ober - und Untergrenzen definiert werden.

Insbesondere ist in einer vorteilhaften Variante vorgesehen, dass der Baustoff bzw. die Baustoffmischung ein oder mehrere Funktionsadditive aufweist, dass die Vernetzung des Wassers verbessert und somit den Wasseranteil an der Verarbeitung des Baustoffes signifikant reduziert.

Vorteilhafter Weise ist vorgesehen, dass der Baustoff verarbeitungsbereit vorgehalten wird. In dieser Variante ist vorgesehen, dass der Baustoff mit konstanter Rezeptur vorgehalten wird und durch diese gleichbleibende Rezeptur auch die Verarbeitung des Baustoffes mit Maschinen, wie zum Beispiel mit Mörtel-Spritzpumpen zuverlässig durchgeführt werden kann. Weiterhin wird dadurch auch ein konstanter Absorptionswert gewährleistet.

Es ist ein weiterer Vorteil der Erfindung, dass die vorgeschlagene Baustoffmischung eine hohe Wärmeleitfähigkeit aufweist. Diese hohe Wärmeleitfähigkeit der Putzmasse führt dazu, dass die Schimmelbildung in Gebäuden reduziert wird. Vorzugsweise tritt die Schimmelbildung in Gebäuden in Raumecken auf, deren Wandtemperatur niedriger ist als die der angrenzenden Wände. Diese Temperaturdifferenzen (>= 3 K) werden durch die hohe Wärmeleitfähigkeit der Putzmasse reduziert, wodurch sich auch die Schimmelbildung reduziert.

Der in der erfindungsgemäßen Baustoffmischung eingesetzte Graphit erhöht erheblich deren elektrische Leitfähigkeit. Weiterhin besitzt sie wie oben beschrieben eine erhöhte Temperaturleitfähigkeit. Da diese Flächen auch geerdet werden können, bilden sich keine elektrostatisch anziehenden Flächen. Somit können Fogging-Effekte (Schwarzstaub) reduziert werden.

Die Erfindung umfasst ferner Bauelemente, insbesondere Trockenbauelemente, umfassend eine Baustoffmischung nach der oben beschriebenen Art bzw. derartige Bauelemente, die unter Verwendung einer solchen Baustoffmischung hergestellt werden. Beispielsweise umfasst die Erfindung auch ein Bauelement wie Fassadenplatten, Fassadenbekleidungen, Lüftungselemente mit absorbierenden Eigenschaften größer 50% und bis 100% gegen elektromagnetische Strahlungen.

Je nach Art der verwendeten Bindemittel, Hilfsstoffe und Zuschlagstoffe kann die Erfindung in unterschiedlichsten Anwendungsbereichen eingesetzt werden.

Wird die erfindungsgemäße Baustoffmischung beispielsweise mit einem Bindemittel, wie Wasserglas, und einem Gewebe verarbeitet, können plattenförmige Bauelemente, beispielsweise Trockenbauplatten, hergestellt werden. Das Wasserglas kann mit einem Härter versehen werden, der so ausgelegt ist, dass die Härtung thermisch beschleunigt werden kann. Derartige Platten haben dann vorteilhafte absorbierende Eigenschaften für elektromagnetische Strahlung, insbesondere hochfrequente elektromagnetische Strahlung wie Mobilfunkstrahlung und Radar. Je nach Ausgestaltung der Platten können die Platten auch in akustischer Hinsicht optimiert werden, beispielsweise indem sie für Schallwellen absorbierend wirken. Beispielsweise sind Platten, die Mikroglaskugeln und Wasserglas als Bindemittel enthalten, als so genannte "Akustikplatten" bekannt und werden beispielsweise unter der Bezeichnung "VeroBoard Acoustic G" von der Firma Verotec GmbH, Lauingen, Deutschland (Sto-Unternehmensgruppe), vertrieben.

Als Bindemittel können auch Zweikomponenten-Polyurea-Silikat-Systeme eingesetzt werden, beispielsweise Materialien, wie sie von der Firma BASF unter der Bezeichnung "Masterroc" für das Verfugen im Bergbau hergestellt werden. Werden derartige Masterroc-Bindemittel (beispielsweise "MasterRoc MP 367 Foam") mit der erfindungsgemäßen Baumischung kombiniert, lassen sich Platten zur Abschirmung gegen elektromagnetische Strahlung herstellen, die sich außerdem durch einen hohen Brandschutz auszeichnen. Da Urea-Silikate als schäumbare Systeme zur Verfügung stehen, zeichnen sich derartige Platten durch eine geringe Dichte aus, so dass sie leichter als vergleichbare Gips-Brandschutzplatten sind. Derartige Ausführungsformen der Erfindung lassen sich daher besonders vorteilhaft als Brandschutzplatten im Schiffbau oder im Flugzeugbau einsetzen. Werden als lose Partikel Hohlkugeln verwendet, können auch derartige Platten neben den hohen Brandschutzeigenschaften hohe akustische Absorptionseigenschaften aufweisen. Im Gegensatz zu den oben beschriebenen "VeroBoard"-Platten mit Wasserglas als Bindemittel sind erfindungsgemäße Platten mit Urea-Silikaten als Bindemittel auch wasserfest.

Durch geeignete Wahl der Bindemittel lassen sich die erfindungsgemäßen Baustoffmischungen auch in Airless-Sprühverfahren einsetzen.

Unter der Produktbezeichnung "SpreFix" sind Brandschutzmittel/Akustikmittel bekannt, mit denen leichte, nicht brennbare und akustisch abschirmende Sprühbeschichtungen hergestellt werden können. Derartige Materialien verwenden ein wasserbasierendes, nicht brennbares Zweikomponenten-Bindemittel, welches in einem Sprühkopf vermischt und nach Austrag aus dem Sprühkopf innerhalb von Sekundenbruchteilen abbindet, so dass bereits bei Auftreffen auf Wände und Decken eine selbsthaftende Schicht entsteht. Derartige Sprühmittel werden insbesondere im Schiffsbau und auf Ölplattformen als Akustik-/Brandschutzdämmung verwendet. Üblicherweise enthält die Dämmung dann auch Glas- oder Mineralfasern. Mit der erfindungsgemäßen Baustoffmischung lassen sich derartige Sprühdämmungssysteme auch mit einer geeigneten abschirmenden Funktion gegen elektromagnetische Strahlung versehen.

Bei Verwendung von Epoxy oder anderen Kunststoffharzen entstehen in Kombination mit der erfindungsgemäßen Baustoffmischung hochfeste, wetterbeständige Oberflächen, die dann eine hohe Absorption für elektromagnetische Strahlung aufweisen. Derartige Systeme zeichnen sich dann durch so genannte Stealth-Eigenschaften aus und können insbesondere im militärischen Bereich zur elektronischen Tarnung von Fahrzeugen, Fluggeräten, Containern und anderen Einrichtungen eingesetzt werden. Derartige Oberflächen sind dann auch mechanisch hoch belastbar. Mit der erfindungsgemäßen Baustoffmischung können so Schaum-Formteile zur Herstellung bzw. Abdeckung von Außenoberflächen von Containern, Fahrzeugen, Flugzeugen und Ähnlichem hergestellt werden, wobei die Dämmung besonders leicht, nicht brennbar, wetterbeständig und gegenüber Radarstrahlung absorbierend ist.

Die vorteilhaften Eigenschaften der erfindungsgemäßen Baustoffmischung, die insbesondere als Putzmasse, Vergussmasse, Betonwerkstein, Konstruktionsmasse für Lüftungsdurchlässe, absorbierende 3D-Druckfähige Baustoffmischung und ähnliches verwendet werden kann, können wie folgt zusammengefasst werden:

- Graphitmodifizierten Putzmasse mit einer Wärmeleitfähigkeit $\lambda \geq 1$ W/mK, insbesondere $\lambda \geq 3$ W/mK.
- Hervorragende Schirmdämpfung für elektromagnetisch Strahlung durch Absorption von über 70% schon bei einer Schichtdicke von rd. 20 mm; durch Erhöhung der Schichtdicke ist eine Absorption von über 99,999 % möglich.
- Oberflächengüten von Q1-Q2 sind erreichbar; das Material ist filzbar.
- Das Material ist maschinengängig und pumpfähig.
- Durch das Anlegen einer Schutzkleinspannung und von elektrisch leitenden Polen kann innerhalb der Putzmasse kann Wärme erzeugt, somit ist sie als Flächenheizung verwendbar.
- Das Material kann formstabil, schnell abbindend und pump- und druckfähig eingestellt werden; Wandstärken von 60-80 mm konnten somit hergestellt werden.
- Die Baustoffmischung ist sehr gut geeignet zum Auftragen von Farben, mittelschwere/schwere Tapeten, Fliesen und keramische Wandbeläge, Strukturputze und zur Herstellung von Flächentemperiersystemen; weiterhin können damit absorbierende Lüftersysteme hergestellt werden, ein Luftaustausch ist somit möglich, aber ein Durchdringen von elektromagnetischer Strahlung wird verhindert. Mit diesem Produkt ergeben sich für uns neue Geschäftsfelder in den Bereichen der Temperierung und Schirmung von Gebäuden.
- Die erfindungsgemäße Baustoffmischung weist eine hohe Schirmdämpfung, vorrangig durch Absorption, hohe Wärmeleitfähigkeit und hohe elektrische Leitfähigkeit auf.
- Zum Erreichen der hohen Wärmeleitfähigkeit und Schirmdämpfung werden Funktionsadditive wie gemahlener Naturgraphit, expandierter Graphit, gemahlener Foliengraphit, synthetischer Graphit, elektrisch leitfähige Fasern, metallische Nanopartikel als Einzeladditiv oder in Kombination miteinander eingesetzt; das Mischungsverhältnis kann auf die jeweiligen Anforderungen angepasst werden.
- Die Baustoffmischung wird in Form einer Trocken- und Nassmischung vorzugsweise eingesetzt als Putzmasse für die Gebäudetechnik, als 3D-druckfähige Masse in der Produktion von Bauteilen und Gebäudestrukturen, und als Vergussmasse für die Herstellung von Baukörpern. Die Verarbeitung der Baustoffmischung ist sowohl handwerklich als auch mittels Putz und Pump/3D-Druckern möglich. Die Baustoffmischung erlaubt auch die Herstellung von nichttragenden Bauelementen wie z.B. Fassadenplatten, Vormauersteinen und Lüftungskonstruktionen .Die Baustoffmischung lässt sich auch durch die Zugabe von Phasenwechselmaterialien (PCM) als latenter Wärmespeicher ausbilden.
- Durch die verwendeten Binder in der Baustoffmischung haftet diese auf nahezu allen Untergründen.

Die Erfindung wird im Folgenden unter Bezugnahme auf die beigefügten Zeichnungen näher erläutert.

In der Zeichnung zeigen:

Figur 1    eine schematische Darstellung eines Schnitts durch ein erfindungsgemäßes Bauelement;

Figur 2    eine schematische Darstellung des Strahlungsverlaufs bei Verwendung von teilweise beschichteten Glaskugeln in der erfindungsgemäßen Baustoffmischung;

Figur 3    eine schematische Darstellung einer Messapparatur zur Untersuchung der erfindungsgemäßen Bauelemente;

Figur 4    eine schematische Darstellung der Absorptionseigenschaften eines aus der erfindungsgemäßen Baustoffmischung hergestellten Bauelements;

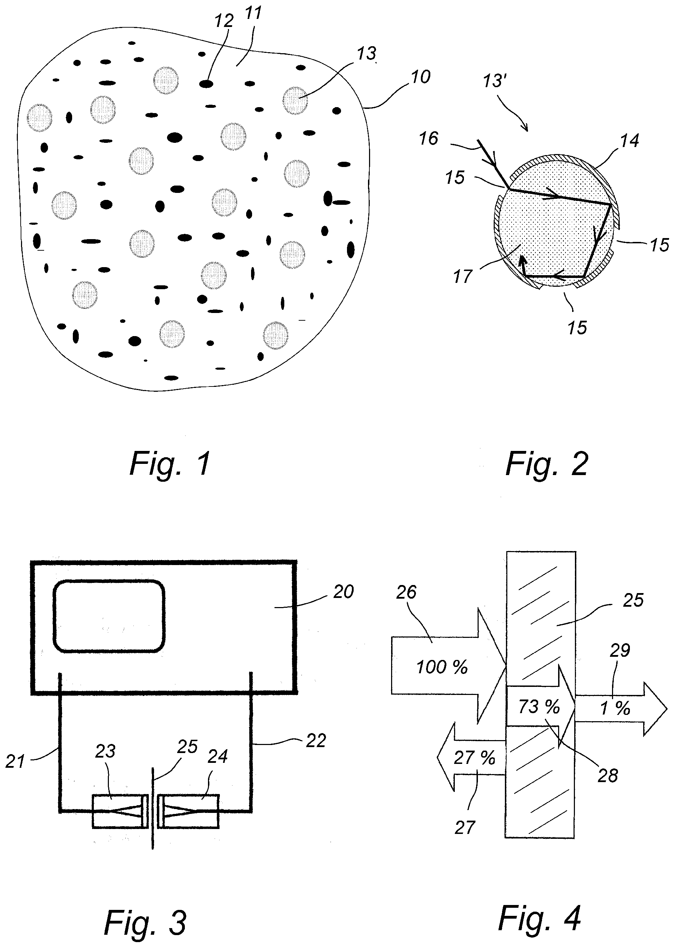

In den Figuren 1 und 2 ist das Funktionsprinzip der erfindungsgemäßen Baustoffmischung erläutert. Ein Bauelement 10, das aus einer erfindungsgemäßen Baustoffmischung hergestellt ist, umfasst ein Bindemittel 11, Graphitanteile 12 im Bindemittel und graphitbeschichtete Kugeln 13. Die Graphitanteile 12 im Bindemittel bewirken an der Oberfläche im Wesentlichen eine Teilreflektion der eintreffenden Strahlung und in tieferliegenden Schichten Reflektionen und Absorption. Die zusätzlichen graphitbeschichteten Kugeln 13 sorgen außerdem für zahlreiche Reflektionen der Strahlung, was den Weg der Strahlung durch das Bauelement 10 vergrößert, was den absorbierten Anteil der Strahlung vergrößert. Der an der Oberfläche des Bauelementes reflektierte Anteil der der Strahlung kann weiter minimiert werden, wenn die der Graphitgehalt im Bindemittel nicht homogen ist, sondern zur Oberfläche des Bauelementes hin abnimmt.

Wenn die graphitbeschichteten Kugeln 13 nicht vollständig mit einer Graphitschicht 14 beschichtet sind, sondern, wie in Figur 2 exemplarisch an einer Kugel 13' gezeigt, unbeschichtete Bereiche 15 aufweisen, kann ein größerer Teil der Strahlung 16 ins Innere 17 der teilbeschichteten Kugeln 13' eintreten und sich durch Mehrfachreflektionen an den beschichteten Grenzflächen im Innern 17 der Kugeln 13' gewissermaßen "totlaufen", was den absorbierten Anteil der Strahlung weiter erhöht.

In Figur 3 ist ein typischer Versuchsaufbau dargestellt, mit welchem die erfindungsgemäßen Baustoffmischungen, die zu plattenförmigen Messobjekten verarbeitet wurden, untersucht wurden. Figur 3 zeigt einen vektoriellen Netzwerkanalysator 20 vom Typ ZVRC von der Firma Rohde und Schwarz, mit dem elektromagnetische Wellen im Frequenzbereich von 30 kHz bis 8 GHz erzeugt und gemessen werden können. Leitung 21, 22 führen zu zwei koaxialen TEM-Messköpfen 23, 24 geleitet werden kann, zwischen denen das Messobjekt 25 angeordnet ist (TEM-Messsonden für den Frequenzbereich 1 MHz - 4 GHz der Firma Wandel und Goltermann). Über die Leitung 21 wird die erzeugte Ausgangsstahlung zu dem Messobjekt 25 und die vom Messobjekt 25 reflektierte Strahlung gemessen. Über die Leitung 22 wird die durch das Messobjekt 25 transmittierte Strahlung dem Netzwerkanalysator zugeleitet. Aus gesendeter, transmittierter und reflektierter Leistung kann dann auch die absorbierte Leistung ermittelt werden.

Bei dieser Messung treffen in der TEM-Anordnung die elektrischen Feldstärken - wie bei koaxialen Leitungen üblich - in allen Polarisationsrichtungen auf das Messobjekt. Damit kann man zwar keine diskreten Aussagen über das Verhalten des Messobjektes gegenüber einer bestimmten linearen Polarisation machen, jedoch bekommt man einen Eindruck, wie sich das Messobjekt gegenüber Polarisationen einer beliebigen Richtung verhalten wird. Schirmt ein Messobjekt bei diesen Messungen besonders gut, wird es auch gegenüber den beiden linearen vertikalen und horizontalen Polarisationen mindestens entsprechend gut schirmen.

Generell kann die Schirmung gegenüber elektromagnetischen Wellen entweder durch Reflexion der Wellen an einer schirmenden Fläche und/oder durch Absorption der Leistung im Schirmmaterial stattfinden. Der Schirmungsanteil der Reflexion hängt von der guten Leitfähigkeit der Schirmfläche ab, die auch durch ihren Flächenwiderstand beschreibbar ist. Die Schirmung der meisten Materialien beruht auf diesem Prinzip. Sind die Materialien sehr gut leitend, können schon sehr dünne Objekte zu hervorragenden Schirmwerten von 80 dB bis über 100 dB führen.

Die Absorption findet innerhalb des Schirmmaterials statt, wenn dieses "verlustbehaftet" ist. Dabei spielt auch die Dicke des Materials eine wesentliche Rolle. Mann kann feststellen, dass alle Stoffe, die beispielsweise in einem Mikrowellenherd schnell warm werden, elektromagnetische Energie im hochfrequenten Wellenbereich gut absorbieren und sich daher auch zum Einsatz in Schirmprodukten eignen.

Um nun bei den Eigenschaften eines Prüfobjekts die durch Reflexion hervorgerufenen Anteile von denen zu trennen, die durch Absorption verursacht werden, muss man neben der Transmission ($S_{21}$) bei dem gleichen Messaufbau in einem geschlossenen System auch noch eine Reflexionsmessung ($S_{11}$) durchführen. Rechnet man nun die gemessen dB-Werte der Transmission und Reflexion in Prozentwerte um, kann man als Leistungsbilanz folgende Gleichung zugrunde legen:

$$P_{transmittiert} = P_{eingestrahlt} - (P_{reflektiert} + P_{absorbiert})$$

Dies bedeutet: Von der auf den Prüfling eingestrahlten Leistung (100%) kommt nur der Leistungsanteil durch den Prüfling hindurch ($P_{transmittiert}$), der nicht reflektiert oder absorbiert wurde.

Beispiel 1

In einer Versuchsmischung "GKB 1" wurde eine Basis aus Gips verwendet (800g Gips-Anhydrit und 130 g Kalk, gelöscht). Durch Zusatz von 500g gemahlenem Naturgraphit (Graphit 99,5) und 120g graphitbeschichteter Glas-Bubbles (Durchmesser 1-2 mm), 100g Magnetit 10 und Funktionsadditiven (250g Sand 0,2-1,5mm, 85g Kalziumkarbonat, 0,14g Rheologieverbesserer Pangel FF, 0,03g Entlüfter Lumiten, 0,20g redispergierbares Polymerpulver ELOTEX MP2100) und durch Zugabe von Wasser wurde eine verarbeitungsfertige Masse hergestellt, welche bei Handauftrag (Anwerfen) eine hervorragende Haftung an einer senkrechten Rigips-Oberfläche aufgewiesen hat. Eine ca. 3 cm dicke Masse blieb ohne Versacken an der Wand haften. Die abbindende Masse konnte nach einer Wartezeit gefilzt werden.

Nach dem vollständigen Abbinden und Trocknung wurde eine 2 cm starke Platte gem. ASTM D - 4935-2010 vermessen.

Die Messung der Schirmdämpfung erfolgte mit einer Apparatur wie in Fig. 3 gegenüber elektromagnetischen Wellen im Frequenzbereich von 10 MHz bis 4,5 GHz und zur Ermittlung der Absorption.

In Figur 4 die jeweiligen Messwerte bezogen auf das Prüfobjekt "GKB1" dargestellt (exemplarisch bei 2450 MHz).

Man erkennt, dass auf das Prüfobjekt 25 wie durch den Peil 26 symbolisiert 100% Leistung eingestrahlt werden. Die gemessene Reflektion ergab einen Return Loss in dB von 5,7 dB. Die daraus ergebende Leistungsreflexion an der Vorderseite bildete einen prozentualen Leistungsreflexionsanteil von 27%, was durch Pfeil 27 symbolisiert wird. 73% der Leistung dringen also in das Prüfobjekt 25 ein (Pfeil 28). Wie durch Pfeil 29 symbolisiert wird 1% der Leistung transmittiert. Die Verluste durch Absorption im Prüfobjekt betragen daher 73% - 1% = 72% der Leistung.

Bei diesem Prüfobjekt wurde daher eine Abschirmdämpfung von 20 dB gemessen. Im Gegensatz zu üblichen Abschirmprodukten weist das erfindungsgemäße Produkt also eine besonders hohe Qualität auf, da ein wesentlich größerer Teil der Leistung absorbiert als reflektiert oder transmittiert wird.

Die geprüften Platten haben folgende Abmessungen 200 mm * 200 mm * 20mm. Da bei der Absorption die Schirmung innerhalb des Schirmmaterials stattfindet, spielt auch die Dicke des Materials eine wesentliche Rolle. Durch Erhöhung der Schichtstärke und Änderung der Reflexionswerte kann die Absorption innerhalb des Schirmes verändert sprich erhöht werden.

Beispiel 2

In der Versuchsmischung "KZ 1" wurde eine Basis aus Kalk-Zement verwendet (800g Weißzement, 120g Kalk, gelöscht). Durch Zusatz von 500g gemahlenem Naturgraphit (Graphit 99,5) und 100g Glas-Bubbles (Perlite 0-1 mm) und Funktionsadditiven (500g Sand 0,2-1,5mm, 0,2g Rheologierverbesserer Pangel FF, 0,02g Entlüfter Lumiten, 0,4g redispergierbares Polymerpulver ELOTEX MP2100 und 0,5g ELOTEX FL2280) und durch Zugabe von Wasser wurde eine verarbeitungsfertige Masse hergestellt, welche bei Handauftrag (Anwerfen) eine hervorragende Haftung an einer senkrechten Rigips-Oberfläche aufgewiesen hat. Eine ca. 3 cm dicke Masse blieb ohne Versacken an der Wand haften. Die abbindende Masse konnte nach einer Wartezeit gefilzt werden. Nach dem vollständigen Abbinden und Trocknung wurde eine 2 cm starke Platte gem. ASTM D - 4935-2010 vermessen. Dabei konnte eine Absorption von 69,5 % ermittelt werden. Auch hier ist durch Erhöhung der Materialstärke eine weitere Steigerung der Absorption erreichbar. So ist auch hier bei einer Materialstärke ab ca. 3 cm eine praktisch 100 %ige Neutralisation der Strahlung erreichbar. Es konnte wieder durch Anspritzen mit Maschinentechnik eine Schichtstärke von 3 cm in einem Arbeitsgang erreicht werden.

Beispiel 3

In der Versuchsmischung "AP 2" wurde eine Basis aus Kalk-Zement verwendet (400g Zement, 400g Kalkm gelöscht). Durch Zusatz 500g gemahlenem Naturgraphit (Graphit 99,5) und 400g Glas-Bubbles (Perlite 0-1mm) und Funktionsadditiven (200g Sand 0,2-1,5mm, 0,02g Entlüfter Lumiten, 0,6g redispergierbares Polymerpulver ELOTEX MP2100 und 0,5g ELOTEX FL2280) und durch Zugabe von Wasser wurde eine verarbeitungsfertige Masse hergestellt, die durch Handauftrag (Anwerfen) eine hervorragende Haftung an einer senkrechten Rigips-Oberfläche aufgewiesen hat. Eine ca. 3 cm dicke Masse blieb ohne Versacken an der Wand haften. Die abbindende Masse konnte nach einer Wartezeit gefilzt werden. Nach dem vollständigen Abbinden und Trocknung wurde eine 2 cm starke Platte gem. ASTM D - 4935-2010 vermessen. Dabei konnte eine Absorption von 67,4 % ermittelt werden.

Durch Erhöhung der Materialstärke ist wieder eine weitere Steigerung der Absorption erreichbar, da dass ab einer Materialstärke von ca. 3 cm eine nahezu 100 %ige Neutralisation der Strahlung erreichbar war. Auch hier konnte durch Anspritzen mit Maschinentechnik eine Schichtstärke von 3 cm in einem Arbeitsgang erreicht werden.

Die durchgeführten Messungen gelten exemplarisch. Generell konnte festgestellt werden, dass die Haftung des Putzes auf weiteren bauüblichen Untergründen wie Ziegelmauerwerk, Betonwerkstein oder Porenbeton als handwerklich sehr gut zu bezeichnen war.

**Patentansprüche**

1. Baustoffmischung, deren Trockenmasse 10 bis 95 Gew.% Kohlenstoff und 2 bis 70 Gew.% Bindemittel umfasst, wobei die Baustoffmischung außerdem 1 bis 80 Gew.% lose Partikel umfasst und die Oberfläche der losen Partikel zumindest teilweise mit einem elektrisch leitfähigen Material vorbeschichtet sind,
**dadurch gekennzeichnet, dass**
der beschichtete Anteil der Oberfläche der losen Partikel im Mittel zwischen 50 und 90% beträgt.

**2.** Baustoffmischung gemäß Anspruche 1, **dadurch gekennzeichnet, dass** die losen Partikel aus einem Glas- oder Keramikmaterial bestehen.

**3.** Baustoffmischung gemäß einem der Ansprüche 1 oder 2, **dadurch gekennzeichnet, dass** die losen Partikel Kugeln, insbesondere Hohlkugeln umfassen.

**4.** Baustoffmischung gemäß einem der Ansprüche 1 bis 3, **dadurch gekennzeichnet, dass** die Größe der losen Partikel im Bereich zwischen 0,01 mm und 10 mm liegt.

**5.** Baustoffmischung gemäß einem der Ansprüche 1 bis 4, **dadurch gekennzeichnet, dass** der Kohlenstoff der Trockenmasse Graphit umfasst.

**6.** Baustoffmischung gemäß einem der Ansprüche 1 bis 5, **dadurch gekennzeichnet, dass** das elektrisch leitfähige Material ausgewählt ist aus der Gruppe bestehend aus Magnetit, Graphit und Graphen oder Kombinationen davon.

**7.** Baustoffmischung gemäß einem der Ansprüche 5 oder 6, **dadurch gekennzeichnet, dass** die der Graphit als Graphitpulver, expandierte Graphitflocken, Foliengraphit, Naturgraphit oder synthetischer Graphit vorliegt.

**8.** Baustoffmischung gemäß einem der Ansprüche 1 bis 7, **dadurch gekennzeichnet, dass** das Bindemittel Kalk, Zement, Gips, Kunststoffe, insbesondere Acrylate oder Polyurea-Silikate, organische Bindemittel, Wasserglas, wasserlösliche Kleber oder Klebstoffe umfasst.

**9.** Baustoffmischung gemäß einem der Ansprüche 1 bis 8, **dadurch gekennzeichnet, dass** die Baustoffmischung außerdem bis zu 50 Gew.% Funktionsadditive umfasst.

**10.** Baustoffmischung gemäß Anspruch 9, **dadurch gekennzeichnet, dass** die Funktionsadditive ausgewählt sind aus der Gruppe bestehend aus Trasspulver, Mikroglashohlkugeln (Glas-Bubbles), Aluminumoxid, Entschäumer, Magnetit, Schwerspat, Verdickungsmittel, Zellulose, Kunststoffadditive, metallische Nanopartikel, insbesondere Silber-Nanopartikel, Fasern und Kombinationen davon.

**11.** Putzmasse, umfassend eine Baustoffmischung nach einem der Ansprüche 1 bis 10.

**12.** Bauelement, umfassend eine Baustoffmischung nach einem der Ansprüche 1 bis 10.

**Claims**

**1.** Construction material mixture, the dry mass of which comprises 10 to 95 percent by weight carbon and 2 to 70 percent by weight binder, wherein the construction material mixture further comprises 1 to 80 percent by weight unconsolidated particles, and the surface of the unconsolidated particles are at least partially pre-coated with an electrically conductive material,
**characterised in that**
the coated portion of the surface of the unconsolidated particles is on average between 50 and 90%.

**2.** Construction material mixture according to claim 1, **characterised in that** the unconsolidated particles consist of a glass or ceramic material.

**3.** Construction material mixture according to one of claims 1 or 2, **characterised in that** the unconsolidated particles comprise spheres, in particular hollow spheres.

**4.** Construction material mixture according to one of claims 1 to 3, **characterised in that** the size of the unconsolidated particles ranges from 0.01mm to 10mm.

**5.** Construction material mixture according to one of claims 1 to 4, **characterised in that** the carbon of the dry mass comprises graphite.

**6.** Construction material mixture according to one of claims 1 to 5, **characterised in that** the electrically conductive material is selected from the group consisting of magnetite, graphite and graphene or combinations thereof.

7. Construction material mixture according to one of claims 5 or 6, **characterised in that** the graphite is present as graphite powder, expanded graphite flakes, film graphite, natural graphite or synthetic graphite.

8. Construction material mixture according to one of claims 1 to 7, **characterised in that** the binder comprises chalk, cement, gypsum, plastics, in particular acrylates or polyurea silicates, organic binders, soluble glass, water-soluble glue or adhesives.

9. Construction material mixture according to one of claims 1 to 8, **characterised in that** the construction material mixture further comprises up to 50 percent by weight functional additives.

10. Construction material mixture according claim 9, **characterised in that** functional additives are selected from the group consisting of trass powder, micro-glass hollow spheres (glass bubbles), aluminium oxide, anti-frothing agent, magnetite, barite, thickener, cellulose, plastic additives, metallic nanoparticles, in particular silver nanoparticles, fibres and combinations thereof.

11. Cleaning mass, comprising a construction material mixture according to one of claims 1 to 10.

12. Construction element, comprising a construction material mixture according to one of claims 1 to 10.

**Revendications**

1. Mélange servant de matériau de construction dont la masse sèche comprend de 10 à 95 % en masse de carbone et de 2 à 70 % en masse de liant, ledit mélange servant de matériau de construction comprenant en outre de 1 à 80 % en masse de particules libres, et la surface desdites particules libres étant prérevêtue au moins partiellement d'un matériau électriquement conducteur,
**caractérisé en ce que**
la proportion revêtue de la surface des particules libres est comprise en moyenne entre 50 et 90%.

2. Mélange servant de matériau de construction selon la revendication 1, **caractérisé en ce que** les particules libres se composent d'un matériau vitreux ou céramique.

3. Mélange servant de matériau de construction selon l'une des revendications 1 et 2, **caractérisé en ce que** les particules libres comprennent des billes, notamment des billes creuses.

4. Mélange servant de matériau de construction selon l'une des revendications 1 à 3, **caractérisé en ce que** la taille des particules libres se situe entre 0,01 mm et 10 mm.

5. Mélange servant de matériau de construction selon l'une des revendications 1 à 4, **caractérisé en ce que** le carbone de la masse sèche comprend du graphite.

6. Mélange servant de matériau de construction selon l'une des revendications 1 à 5, **caractérisé en ce que** le matériau électriquement conducteur est choisi dans le groupe constitué par la magnétite, le graphite et le graphène, ou des combinaisons de ceux-ci.

7. Mélange servant de matériau de construction selon l'une des revendications 5 et 6, **caractérisé en ce que** le graphite est présent sous la forme de poudre de graphite, flocons de graphite expansés, graphite en feuilles, graphite naturel ou graphite synthétique.

8. Mélange servant de matériau de construction selon l'une des revendications 1 à 7, **caractérisé en ce que** le liant est de la chaux, du ciment, du gypse, des matières synthétiques, notamment des acrylates ou bien des silicates de polyurée, des liants organiques, du verre liquide, des adhésifs ou colles solubles à l'eau.

9. Mélange servant de matériau de construction selon l'une des revendications 1 à 8, **caractérisé en ce que** le mélange servant de matériau de construction comprend en outre jusqu'à 50 % en masse d'additifs fonctionnels.

10. Mélange servant de matériau de construction selon la revendication 9, **caractérisé en ce que** les additifs fonctionnels sont choisis dans le groupe constitué par la poudre de trass, les microbilles de verre creuses (glas bubbles), l'alumine, les agents anti-mousses, la magnétite, le baryte, les épaississants, la cellulose, des additifs synthétiques, les nanoparticules métalliques, notamment les nanoparticules d'argent, les fibres et des combinaisons de ceux-ci.

**11.** Crépi comprenant un mélange servant de matériau de construction selon l'une des revendications 1 à 10.

**12.** Élément de construction comprenant un mélange servant de matériau de construction selon l'une des revendications 1 à 10.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016087673 A1